Europäisches Patentamt

European Patent Office

Office européen des brevets

(11) Publication number: **0 615 954 A1**

## EUROPEAN PATENT APPLICATION

(21) Application number: **94103535.4**

(51) Int. Cl.5: **C01B 31/06, C30B 33/00**

(22) Date of filing: **08.03.94**

(30) Priority: **15.03.93 JP 53959/93**

(43) Date of publication of application:
**21.09.94 Bulletin 94/38**

(84) Designated Contracting States:
**BE DE FR GB IE**

(71) Applicant: **SUMITOMO ELECTRIC INDUSTRIES, LIMITED**
**5-33, Kitahama 4-chome**
**Chuo-ku**
**Osaka 541 (JP)**

(72) Inventor: **Satoh, Shuichi, c/o Itami Works of**
**Sumitomo Elec. Ind., Ltd.,**
**1-1, Koyakita 1-chome**
**Itami-shi, Hyogo (JP)**
Inventor: **Sumiya, Hitoshi, c/o Itami Works of**
**Sumitomo Elec. Ind., Ltd.,**
**1-1, Koyakita 1-chome**
**Itami-shi, Hyogo (JP)**

(74) Representative: **Kirschner, Klaus Dieter,**
**Dipl.-Phys.**
**Patentanwälte**
**Herrmann-Trentepohl, Kirschner,**
**Grosse, Bockhorni & Partner**
**Forstenrieder Allee 59**
**D-81476 München (DE)**

(54) **Red diamond, pink diamond and method of producing the same.**

(57) In a red diamond according to the present invention, an absorption coefficient of type Ib nitrogen at 500 nm is at least 0.1 cm$^{-1}$ and less than 0.2 cm$^{-1}$, an absorption coefficient of an N-V center at an absorption peak of 570 nm is at least 0.05 cm$^{-1}$ and less than 1 cm$^{-1}$, and an absorption coefficient of a GR1 center, an H2 center, an H3 center and/or an H4 center in a visible region is not more than 0.2 cm$^{-1}$. In a pink diamond according to the present invention, an absorption coefficient of type Ib nitrogen at 500 nm is less than 0.1 cm$^{-1}$, and an absorption coefficient of an N-V center at an absorption peak of 570 nm is at least 0.005 cm$^{-1}$ and less than 0.3 cm$^{-1}$.

EP 0 615 954 A1

BACKGROUND OF THE INVENTION

Field of the Invention

The present invention relates to a red diamond and a pink diamond which are suitable for decorative use, for example, and methods of producing the same.

Description of the Background Art

In general, a colored diamond has been obtained by irradiating a natural rough diamond with an electron beam and thereafter annealing the same under a vacuum for producing a color center in the natural diamond thereby coloring the same.

Such a color center is formed by bonding between nitrogen atoms contained in the diamond crystals and lattice defects which are caused by electron beam irradiation. There also exists a color center consisting of only lattice defects. The type of the color center depends on the state of condensation of the nitrogen atoms. Table 1 shows relations between respective color centers and colors thereof.

## Table 1

| Item Name of Center | State of Bonding of Color Center | Color of Color Center |
|---|---|---|
| H3 Center | Bonding between Paired Nitrogen and Lattice Defect | Yellow |
| H4 Center | Bonding between Double-Paired Nitrogen and Lattice Defect | Yellow |
| N-V Center | Bonding between Isolated Nitrogen and Lattice Defect | Purple |
| GR1 Center | Lattice Defect | Purple |
| N3 Center | Bonding of Triple Nitrogen (Naturally Existent) | Pale Yellow |

Methods of creating the respective color centers shown in Table 1 and characteristics thereof are described in "Optical Absorption and Luminescence" by John Walker, Reports on Progress Physics, Vol. 42, 1979. After creation of such color centers, the diamonds present colors which are attained by superposition of original colors thereof with the colors shown in Table 1.

Original colors of natural rough diamonds are classified as shown in Table 2.

## Table 2

| Item Type of Diamond | Color of Rough Diamond | State of Existence of Nitrogen | | | | Rate of Natural Existence |
|---|---|---|---|---|---|---|
| | | Isolated Nitrogen | Paired Nitrogen | Double-Paired Nitrogen | Triple Nitrogen | |
| IIa | Transparent /Colorless | No | No | No | No | 1% |
| Ia | Transparent /Colorless | No | Yes | Yes | No | 10% |
| | Pale Yellow | No | Yes | Yes | Small | 90% |
| | Yellow | Yes | Yes | Yes | Yes | |
| | Brown | Large | Yes | Yes | Large | |
| IIb | Blue | No (Contains B) | No | No | No | Almost 0% |
| Ib | Light Yellow | Yes | No | No | No | 0.2% |

In a general method, it has been impossible to obtain a red or pink diamond by creating a color center in a natural or synthetic diamond. Naturally produced colored diamonds rarely include pink ones, while it is difficult to obtain such pink diamonds in practice in consideration of the output quantity and the cost. On the other hand, a red diamond has been neither naturally produced nor existent.

It has been impossible to color a synthetic or natural diamond red or pink, for the following reasons:

(1) The type of the color center to be selected and the range of its concentration (absorption coefficient) to be selected have been unknown.

(2) The optimum color of the rough diamond for serving as a base has been unknown.

(3) The contents of necessary production conditions have been unknown.

SUMMARY OF THE INVENTION

An object of the present invention is to provide a red or pink diamond, which has been substantially non-existent in general.

Another object of the present invention is to provide a method of producing a red or pink diamond.

A red diamond which is obtained according to the present invention has the following characteristics:

(1) An absorption coefficient of type Ib nitrogen at 500 nm is at least 0.1 cm$^{-1}$ and less than 0.2 cm$^{-1}$.

(2) An absorption coefficient of an N-V center at an absorption peak of 570 nm is at least 0.05 cm$^{-1}$ and less than 1 cm$^{-1}$.

(3) An absorption coefficient of a GR1 center, an H2 center, an H3 center and/or an H4 center in a visible region is not more than 0.2 cm$^{-1}$.

A pink diamond which is obtained according to the present invention has the following characteristics:

(1) An absorption coefficient of type Ib nitrogen at 500 nm is less than 0.1 cm$^{-1}$.

(2) An absorption coefficient of an N-V center at an absorption peak of 570 nm is at least 0.005 cm$^{-1}$ and less than 0.3 cm$^{-1}$.

The inventors have found that it is necessary to employ an N-V center as the color center while extremely reducing its concentration, in order to obtain a red or pink diamond.

The inventors have also found that the rough diamond for serving as a base is preferably as transparent as possible in order to obtain a pink diamond, while that for obtaining a red diamond is preferably yellowish. A yellowish rough diamond is optimumly prepared from a synthetic type Ib diamond which consists of only Ib nitrogen forming only an N-V center as the color center.

The inventors have investigated relations between colors of finally obtained diamonds and absorption coefficients of N-V centers at absorption peaks of 570 nm, to obtain the following results:

(1) A pink diamond was obtained when the absorption coefficient was at least 0.005 cm$^{-1}$ and less than 0.3 cm$^{-1}$. On the other hand, a substantially transparent diamond was obtained when the absorption coefficient was less than 0.005 cm$^{-1}$, while a purple diamond was obtained when the absorption coefficient was in excess of 0.3 cm$^{-1}$.

(2) A red diamond was obtained when the absorption coefficient was at least 0.05 cm$^{-1}$ and less than 1.0 cm$^{-1}$.

On the other hand, the color of the rough diamond serving as a base was so conspicuous that the diamond as obtained presented no red color when the absorption coefficient was less than 0.05 cm$^{-1}$, while a purple diamond was obtained when the absorption coefficient was in excess of 1.0 cm$^{-1}$.

Absorption by type Ib nitrogen has action of coloring a rough diamond for serving as a base yellow. This action is unnecessary for obtaining a pink diamond, and hence concentration of type Ib nitrogen is preferably minimized in this case. In more concrete terms, it is necessary to reduce the absorption coefficient of type Ib nitrogen at 500 nm to less than 0.1 cm$^{-1}$, in order to obtain a pink diamond. When the absorption coefficient was in excess of 0.1 cm$^{-1}$, the rough diamond was made yellowish, or colored red.

In order to obtain a red diamond, on the other hand, it is necessary to superpose the color resulting from the N-V center with that of the rough diamond for serving as a base. When the absorption coefficient of type Ib nitrogen at 500 nm was at least 0.1 cm$^{-1}$ and less than 0.2 cm$^{-1}$, the finally obtained diamond was colored red. However, a purple or pink diamond was obtained when the absorption coefficient was less than 0.1 cm$^{-1}$, while a yellowish diamond was obtained when the absorption coefficient was in excess of 0.2 cm$^{-1}$.

The color of a red diamond is made turbid and reduced in clearness when another absorption by a GR1 center, an H2 center, an H3 center and/or an H4 center takes place in a visible region. In order to maintain the clearness, it is important that the coefficient of such absorption is not more than 0.2 cm$^{-1}$.

When the rough diamond serving as a base contains boron, a black center is disadvantageously formed when the rough diamond is irradiated with an electron beam or a neutron beam, to black the overall diamond. In order to obtain a pink diamond, therefore, it is preferable to reduce the boron content to not more than 5 x 10$^{17}$ atoms/cm$^3$, while it is preferable to reduce the boron content to not more than 1 x 10$^{18}$ atoms/cm$^3$ in order to obtain a red diamond.

It is possible to obtain a diamond which is suitable for decorative use by brilliant-cutting the aforementioned red or pink diamond.

The aforementioned red diamond is produced through the following steps:

(1) A step of preparing a synthetic diamond crystal containing at least 1 x 10$^{17}$ and not more than 4 x 10$^{18}$ atoms/cm$^3$ of type Ib nitrogen and not more than 1 x 10$^{18}$ atoms/cm$^3$ of boron.

(2) A step of irradiating the diamond crystal with an electron beam of at least 2 x 10$^{15}$ and not more than 5 x 10$^{16}$ electrons/cm$^2$ in density at energy of 1 to 10 MeV.

(3) A step of annealing the diamond crystal which has been irradiated with the electron beam in a vacuum atmosphere or an inert gas atmosphere of not more than 10$^{-1}$ Torr at a temperature of at least 600 °C and not more than 800 °C for at least 3 hours.

The diamond crystal may be irradiated with a neutron beam in a density range of 2 x 10$^{15}$ to 8 x 10$^{17}$/cm$^2$, in place of the electron beam.

On the other hand, the aforementioned pink diamond is produced through the following steps:

(1) A step of preparing a synthetic diamond crystal containing at least 3 x 10$^{16}$ atoms/cm$^3$ and not more than 8 x 10$^{17}$ atoms/cm$^3$ of type Ib nitrogen and not more than 5 x 10$^{17}$ atoms/cm$^3$ of boron.

(2) A step of irradiating the diamond crystal with an electron beam of 1 x 10$^{16}$ to 1 x 10$^{18}$ electrons/cm$^2$ in density at energy of 1 to 10 MeV.

(3) A step of annealing the diamond crystal which has been irradiated with the electron beam in a vacuum atmosphere or an inert gas atmosphere of not more than 10$^{-1}$ Torr at a temperature of 800 to 1100 °C for at least 3 hours.

In the aforementioned step (2), the diamond crystal may be irradiated with a neutron beam in a density range of 2 x 10$^{15}$ to 8 x 10$^{17}$/cm$^2$, in place of the electron beam.

The synthetic diamond crystal containing prescribed amounts of type Ib nitrogen and boron is irradiated with an electron beam or a neutron beam, to form lattice defects in the crystal. Thereafter the diamond crystal is annealed in a prescribed temperature range, so that nitrogen atoms are bonded with the lattice defects to form a color center.

In order to produce a red diamond, the electron beam irradiation density is set in a range of at least 2 x 10$^{15}$ and not more than 10$^{16}$ electrons/cm$^2$, since it is possible to homogeneously form lattice defects in the overall crystal by electron beam irradiation within this range. When the density is lower than the aforementioned range, concentration of the lattice defects is so reduced that it is impossible to form a color center in prescribed concentration. When the density exceeds the aforementioned range, on the other hand, the lattice defects finally remain to color the diamond grey. When the diamond crystal is irradiated with a neutron beam in place of the electron beam, the density of the neutron beam is preferably set in a range of $2 \times 10^{15}$ to $8 \times 10^{17}/cm^2$, for reasons similar to the above.

In order to produce a pink diamond, on the other hand, the optimum electron beam irradiation density is set in a range of $1 \times 10^{16}$ to $1 \times 10^{18}$ electrons/$cm^2$. When the diamond crystal is irradiated with a neutron beam in place of the electron beam, the density of the neutron beam is set in a range of $2 \times 10^{15}$ to $8 \times 10^{17}/cm^2$.

The annealing conditions for producing a red diamond are a temperature of at least 600°C and less than 800°C and a time of at least 3 hours, since it is possible to efficiently bond the lattice defects and the nitrogen atoms with each other under such conditions. If the annealing temperature is less than 600°C or the annealing time is less than 3 hours, the nitrogen atoms are so weakly bonded with the lattice defects that it is impossible to attain the target color. When the annealing temperature is in excess of 800°C, on the other hand, a color center once formed disappears to provide a purple diamond.

Optimum annealing conditions for producing a pink diamond are a temperature of 800 to 1100°C and a time of at least 3 hours, for reasons similar to the above.

The diamond crystal is annealed in a vacuum atmosphere or an inert gas atmosphere of not more than $10^{-1}$ Torr, in order to prevent the diamond from oxidation or graphitization under a high temperature.

Thus, according to the present invention, it is possible to obtain a red or pink diamond which is suitable for decorative use.

The foregoing and other objects, features, aspects and advantages of the present invention will become more apparent from the following detailed description of the present invention.

DESCRIPTION OF THE PREFERRED EMBODIMENTS

Example 1

A very high pressure apparatus was employed to synthesize diamonds of 0.6 to 0.8 carats on seed crystals by the temperature gradient method under conditions of a pressure of 5.5 GPa and a temperature of 1350°C. In such synthesis, solvents were prepared from Fe-Co-Al alloys, and the amounts of Al were varied to vary nitrogen contents in the crystals. Further, various materials of different purity levels were selected for forming the alloys, to vary boron contents in the crystals.

The diamond crystals were irradiated with electron beams under conditions of energy of 1 MeV and a density of $1 \times 10^{16}$ electrons/$cm^2$. Then the diamond crystals were annealed in an Ar gas atmosphere at a temperature of 1100°C for 3 hours.

The diamond crystals as synthesized were worked into flat plates, and subjected to measurement of absorption coefficients of type Ib nitrogen at 500 nm and those of N-V centers at 570 nm with a visible spectrophotometer. Further, nitrogen contents and boron contents in the crystals were measured with an ESR and an SIMS respectively. Table 3 shows the results.

Table 3

| Experiment No. | 1 | 2 | 3 | 4 | 5 | 6 |
|---|---|---|---|---|---|---|
| Absorption Coefficient of N-V Center | 0.003 (1/cm) | 0.005 (1/cm) | 0.1 (1/cm) | 0.25 (1/cm) | 0.3 (1/cm) | 0.20 (1/cm) |
| Absorption Coefficient of Ib Nitrogen | 0.05 (1/cm) | 0.05 (1/cm) | 0.08 (1/cm) | 0.1 (1/cm) | 0.2 (1/cm) | 0.09 (1/cm) |
| Nitrogen Content (/cm$^3$) | $1.7 \times 10^{16}$ | $3 \times 10^{16}$ | $5 \times 10^{17}$ | $7 \times 10^{17}$ | $8 \times 10^{18}$ | $6 \times 10^{17}$ |
| Boron Content (/cm$^3$) | $2 \times 10^{17}$ | $1 \times 10^{17}$ | $3 \times 10^{17}$ | $5 \times 10^{17}$ | $5 \times 10^{17}$ | $8 \times 10^{7}$ |
| Color | Colorless | Pale Pink | Pink | Pink | Purple | Blacky Pink |
| | Comparative Example | Example | Example | Example | Comparative Example | Comparative Example |

When samples corresponding to Experiments Nos. 2, 3 and 4 were brilliant-cut, beautiful pink decorative diamonds were obtained.

As to samples according to Experiments Nos. 1 to 4, only N-V centers were recognized with no presence of other centers (H2, H3 and GR1 centers).

The electron beams were replaced by neutron beams of $2 \times 10^{15}/\text{cm}^2$ in density to carry out similar experiments, whereby similar effects were attained.

Example 2

A very high pressure apparatus was employed to synthesize diamonds of 0.7 to 0.8 carats on seed crystals under conditions of a pressure of 5.4 GPa and a temperature of 1380°C. Solvents were prepared from Fe-Co-Al alloys and the amounts of Al were varied to vary nitrogen contents in the crystals.

The diamond crystals were irradiated with electron beams under conditions of energy of 10 MeV and a density of $1 \times 10^{16}$ electrons/$\text{cm}^2$. Then the diamond crystals were annealed in a vacuum of $10^{-1}$ Torr.

Nitrogen contents and boron contents were measured in a similar manner to Example 1. Table 4 shows the results.

Table 4

| Experiment No. | 11 | 12 | 13 | 14 | 15 | 16 | 17 |
|---|---|---|---|---|---|---|---|
| Absorption Coefficient of N-V center | 0.04 (1/cm) | 0.05 (1/cm) | 0.2 (1/cm) | 0.9 (1/cm) | 1.0 (1/cm) | 0.2 (1/cm) | 0.2 (1/cm) |
| Absorption Coefficient of Ib Nitrogen | 0.15 (1/cm) | 0.10 (1/cm) | 0.12 (1/cm) | 0.18 (1/cm) | 0.25 (1/cm) | 0.22 (1/cm) | 0/14 (1/cm) |
| Absorption Coefficient of Another Centers | 0 (1/cm) | 0 (1/cm) | 0.05 (1/cm) | 0.2 (1/cm) | 0.1 (1/cm) | 0.07 (1/cm) | 0.01 (1/cm) |
| Nitrogen Content (/cm$^3$) | $3 \times 10^{17}$ | $1 \times 10^{17}$ | $7 \times 10^{18}$ | $3.5 \times 10^{18}$ | $4 \times 10^{18}$ | $1 \times 10^{18}$ | $3 \times 10^{18}$ |
| Boron Content (/cm$^3$) | $2 \times 10^{17}$ | $5 \times 10^{17}$ | $5 \times 10^{17}$ | $1.0 \times 10^{18}$ | $5 \times 10^{17}$ | $5 \times 10^{17}$ | $2.0 \times 10^{18}$ |
| Annealing Temperature | 900 °C | 600 °C | 700 °C | 790 °C | 800 °C | 900 °C | 700 °C |
| Color | Pale Yellow | Red | Red | Red | Purple | Purple | Blackish Red |
|  | Comparative Example | Example | Example | Example | Comparative Example | Comparative Example | Comparative Example |

When samples according to Experiments Nos. 12 to 14 were brilliant-cut, beautiful red decorative diamonds were obtained.

The electron beams were replaced by neutron beams of $8 \times 10^{17}/cm^2$ in density to carry out similar experiments, whereby similar results were attained.

Although the present invention has been described and illustrated in detail, it is clearly understood that the same is by way of illustration and example only and is not to be taken by way of limitation, the spirit and scope of the present invention being limited only by the terms of the appended claims.

**Claims**

1. A red diamond, wherein
an absorption coefficient of type Ib nitrogen at 500 nm is at least 0.1 cm$^{-1}$ and less than 0.2 cm$^{-1}$;
an absorption coefficient of an N-V center at an absorption peak of 570 nm is at least 0.05 cm$^{-1}$ and less than 1 cm$^{-1}$, and
an absorption coefficient of a GR1 center, an H2 center, an H3 center and/or an H4 center in a visible region is not more than 0.2 cm$^{-1}$.

2. A red diamond in accordance with claim 1, wherein a boron content is less than $1 \times 10^{18}$ atoms/cm$^3$.

3. A decorative red diamond being obtained by brilliant-cutting a red diamond in accordance with claim 1.

4. A pink diamond, wherein
an absorption coefficient of type Ib nitrogen at 500 nm is less than 0.1 cm$^{-1}$; and
an absorption coefficient of an N-V center at an absorption peak of 570 nm is at least 0.005 cm$^{-1}$ and less than 0.3 cm$^{-1}$.

5. A pink diamond in accordance with claim 4, wherein a boron content is less than $5 \times 10^{17}$ atoms/cm$^3$.

6. A decorative pink diamond being obtained by brilliant-cutting a pink diamond in accordance with claim 4.

7. A method of producing a red diamond, comprising the steps of:

preparing a synthetic diamond crystal containing at least $1 \times 10^{17}$ and less than $4 \times 10^{18}$ atoms/cm$^3$ of type Ib nitrogen, and less than $1 \times 10^{18}$ atoms/cm$^3$ of boron;

irradiating said diamond crystal with an electron beam at energy of 1 to 10 MeV in a density range of $2 \times 10^{15}$ to $5 \times 10^{16}$ electrons/cm$^2$, or with a neutron beam in a density range of $2 \times 10^{15}$ to $8 \times 10^{17}$/cm$^2$; and

annealing said diamond crystal, being irradiated with said electron beam or said neutron beam, in a vacuum atmosphere or an inert gas atmosphere of not more than $10^{-1}$ Torr at a temperature of at least 600 °C and less than 800 °C for at least 3 hours.

8. A method of producing a pink diamond, comprising the steps of:

preparing a synthetic diamond crystal containing at least $3 \times 10^{16}$ atoms/cm$^3$ and less than $8 \times 10^{17}$ atoms/cm$^3$ of type Ib nitrogen, and less than $5 \times 10^{17}$ atoms/cm$^3$ of boron;

irradiating said diamond crystal with an electron beam at energy of 1 to 10 MeV in a density range of $1 \times 10^{16}$ to $1 \times 10^{18}$ electrons/cm$^2$, or with a neutron beam in a density range of $2 \times 10^{15}$ to $8 \times 10^{17}$/cm$^2$; and

annealing said diamond crystal, being irradiated with said electron beam or said neutron beam, in a vacuum atmosphere or an inert gas atmosphere of not more than $10^{-1}$ Torr at a temperature of 800 °C to 1100 °C for at least 3 hours.

## DOCUMENTS CONSIDERED TO BE RELEVANT

| Category | Citation of document with indication, where appropriate, of relevant passages | Relevant to claim | CLASSIFICATION OF THE APPLICATION (Int.Cl.5) |
|---|---|---|---|
| A | EP-A-0 316 856 (SUMITOMO ELECTRIC INDUSTRIES LIMITED) * claims 1,2 * | 1,7 | C01B31/06 C30B33/00 |
| A | EP-A-0 324 179 (SUMITOMO ELECTRIC INDUSTRIES LIMITED) * claims 1,2 * | 1,7 | |

**TECHNICAL FIELDS SEARCHED (Int.Cl.5)**

C01B
C30B

The present search report has been drawn up for all claims

| Place of search | Date of completion of the search | Examiner |
|---|---|---|
| BERLIN | 30 May 1994 | Clement, J-P |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document